(19) Europäisches Patentamt

European Patent Office

Office européen des brevets

(11) Veröffentlichungsnummer: **0 386 282 B1**

(12) **EUROPÄISCHE PATENTSCHRIFT**

(45) Veröffentlichungstag der Patentschrift: **29.12.93**

(21) Anmeldenummer: **89103923.2**

(22) Anmeldetag: **06.03.89**

(51) Int. Cl.⁵: **G05F 3/20**, G11C 11/407

(54) **Integrierte Referenzspannungsquelle.**

(43) Veröffentlichungstag der Anmeldung:
**12.09.90 Patentblatt 90/37**

(45) Bekanntmachung des Hinweises auf die
Patenterteilung:
**29.12.93 Patentblatt 93/52**

(84) Benannte Vertragsstaaten:
**AT DE FR GB IT NL**

(56) Entgegenhaltungen:
**EP-A- 0 032 588      EP-A- 0 113 187**
**EP-A- 0 195 525      EP-A- 0 200 500**
**DE-A- 3 705 147      US-A- 4 250 414**

(73) Patentinhaber: **SIEMENS AKTIENGESELL-
SCHAFT
Wittelsbacherplatz 2
D-80333 München(DE)**

(72) Erfinder: **Hoffmann Kurt, Dr., Prof.
Nelkenweg 20
D-8021 Taufkirchen(DE)**

**Beschreibung**

Die Erfindung betrifft eine integrierte Referenzspannungsquelle.

Bei integrierten Halbleiterspeichern vom Typ DRAM mit 1-Transistor-Speicherzellenist es üblich, die Kondensatoren der Speicherzellen einseitig mit einem festen Potential zu verbinden. Früher war dies meist eines der Versorgungspotentiale VCC,VSS des gesamten Halbleiterspeichers. Mittlerweile ist es üblich, stattdessen ein Potential zu verwenden, das wertemäßig zwischen den beiden Versorgungspotentialen liegt.

Aufgabe der vorliegenden Erfindung ist es, eine integrierte Referenzspannungsquelle zu schaffen, die im Betrieb als Ausgangsspannung eine Referenzspannung liefert, die wertemäßig zwischen den beiden Versorgungspotentialen liegt, deren Wert durch einfache Dimensionierungsvorschriften festlegbar ist, deren Wert weiterhin möglichst stabil ist und die möglichst einfach aufgebaut ist, insbesondere um Fläche zu sparen.

Die Aufgabe wird bei einer integrierten Referenzspannungsquelle gelöst durch die Merkmale des Patentanspruches 1. Vorteilhafte Aus- und Weiterbildungen sind in Unteransprüchen gekennzeichnet.

Die Erfindung wird im folgenden anhand der Zeichnung erläutert. Es zeigen:
die FIG 1, 3        vorteilhafte Ausgestaltungen der Erfindung,
FIG 2                 ein Impulsdiagramm bezüglich FIG 1,
FIG 4                 eine Anwendung der Erfindung bei einem integrierten Halbleiterspeicher.

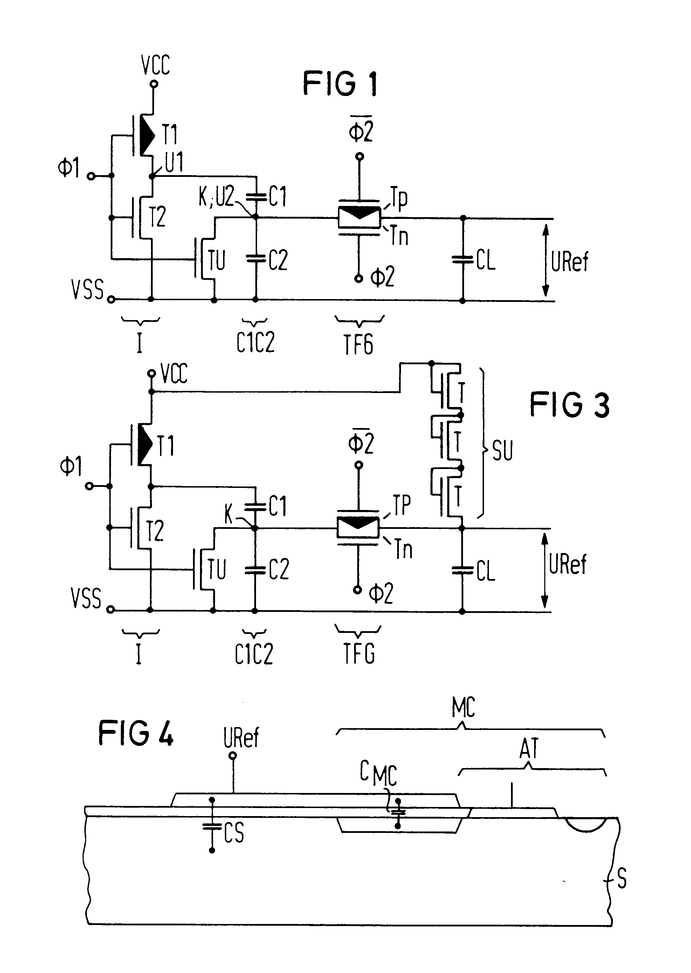

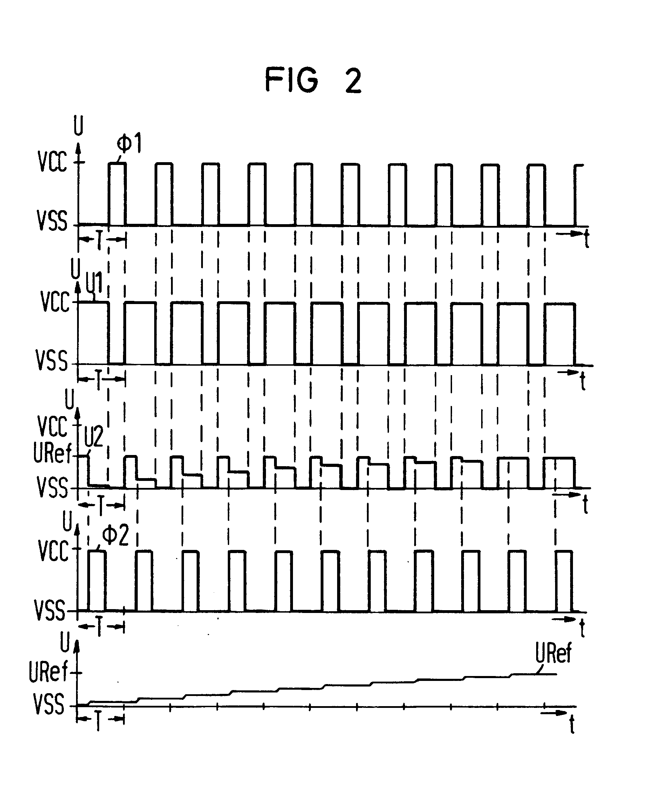

FIG 1 zeigt einen CMOS-Inverter 1, der mit seinen Transistoren T1,T2 zwischen ein erstes Versorgungspotential VCC und ein zweites Versorgungspotential VSS geschaltet ist. Üblicherweise sind dies die Versorgungspotentiale eines größeren integrierten Halbleiterschaltungskomplexes, in den die Erfindung integriert ist. Typische Werte für die Potentiale sind beispielsweise 5 V und 0 V. Der CMOS-Inverter I ist im Betrieb eingangsseitig mit einem ersten Taktsignal Ø1 verbunden. Ausgangsseitig ist der CMOS-Inverter I mit dem einen Ende einer kapazitiven Spannungsteilerschaltung C1C2 verbunden. Das andere Ende der Spannungsteilerschaltung C1C2 ist mit dem zweiten Versorgungspotential VSS verbunden. Die Spannungsteilerschaltung C1C2 enthält vorteilhafterweise zwei in Serie zueinander geschaltete Kapazitäten C1 und C2 unter Bildung eines Verbindungsknotens K zwischen den Kapazitäten C1 und C2.

Der Verbindungsknoten K ist einerseits mit einem Entladetransistor TU verbunden und andererseits mit einem Transfergate TFG. Das Transfergate TFG ist durch ein zweites Taktsignal Ø2 gesteuert. Die Source des Entladetransistors TU ist mit dem zweiten Versorgungspotential VSS verbunden. Sein Gate ist im Betrieb ebenfalls mit dem ersten Taktsignal Ø1 verbunden. Das Transfergate TFG ist ausgangsseitig mit einer Stützkapazität CL verbunden unter Bildung des Ausganges der Referenzspannungsquelle. Die Stützkapazität CL ist außerdem mit dem zweiten Versorgungspotential VSS verbunden. Im eingeschwungenen Zustand der Referenzspannungsquelle liegt an ihrem Ausgang die gewünschte Referenzspannung URef an. Der Wert der Referenzspannung URef im eingeschwungenen Zustand ergibt sich im wesentlichen nach folgender Formel:

$$\mathrm{URef} = (\mathrm{VDD} - \mathrm{VSS}) \cdot \frac{\mathrm{C1}}{\mathrm{C1} + \mathrm{C2}} \; .$$

Die Bestandteile der Formel sind die Werte der mit demselben Bezugszeichen versehenen Elemente bzw. elektrischen Potentiale.

FIG 2 zeigt den zeitlichen Verlauf verschiedener Signale und Potentiale im Einschwingzustand der integrierten Referenzspannungsquelle, d.h. in einem Zeitraum, der von einem Anfangszustand ("Power-on"-Situation) bis zum Erreichen des eingeschwungenen Zustandes reicht. Dargestellt sind die Taktsignale Ø1 und Ø2, der Spannungsverlauf U1 am Ausgang des Inverters I, der Spannungsverlauf U2 am Verbindungsknoten K sowie der Verlauf der Referenzspannung URef. Das Diagramm ist in Taktperioden T eingeteilt.

Zunächst ist das erste Taktsignal Ø1 auf log. 0. Dadurch entsteht am Ausgang des Inverters I eine Spannung U1 mit dem Wert log. 1. Die Spannung U1 bewirkt aufgrund der Spannungsteilerwirkung der kapazitiven Spannungsteilerschaltung C1C2 am Verbindungsknoten K eine Knotenspannung U2 mit dem Wert

$$\mathrm{U2} = (\mathrm{VDD} - \mathrm{VSS}) \cdot \frac{\mathrm{C1}}{\mathrm{C1} + \mathrm{C2}} \; .$$

2

Unter der (beispielhaften) Annahme, daß VDD = 5 V, VSS = 0 V sei und daß die beiden Kapazitäten C1 und C2 gleiche Werte aufweisen, ist also U2 = 2,5 V.

Anschließend daran wird das zweite Taktsignal Ø2 aktiviert, das Transfergate TFG schaltet durch. Da zu diesem Zeitpunkt die Stützkapazität CL noch entladen ist, findet ein Potentialausgleich statt zwischen dem Verbindungsknoten K und der am Ausgang der Referenzspannungsquelle liegenden Stützkapazität CL, wodurch die Knotenspannung U2 deutlich absinkt. Nun wird das Transfergate TFG wieder gesperrt (zweites Taktsignal Ø2 nimmt den Wert log. 0 an) und das erste Taktsignal Ø2 nimmt den Wert log. 1 an. Letzteres bewirkt, daß am Ausgang des CMOS-Inverters I die Spannung U1 den Wert log. 0 annimmt, unterstützt durch den Entladetransistor TU (leitet wegen des ersten Taktsignales Ø1).

Zu Beginn der nächsten Taktperiode nimmt das erste Taktsignal Ø1 wiederum den Wert log. 0 an. Die Spannungen U1 und U2 sowie die beiden Taktsignale Ø1,Ø2 verhalten sich im weiteren Verlauf entsprechend ihren bereits beschriebenen Verläufen mit folgendem Unterschied: Die Stützkapazität CL ist aufgrund des vorhergehenden Taktes T (bzw. der vorhergehenden Takte T) bereits auf einen gewissen Wert aufgeladen. Deswegen sinkt die Knotenspannung U2 bei Leitend-Schalten des Transfergates TFG immer weniger ab, bis auch sie letztendlich im eingeschwungenen Zustand im wesentlichen den Wert der Referenzspannung URef annimmt. Entsprechend steigt die Referenzspannung URef von Taktperiode zu Taktperiode immer mehr an, bis sie letztendlich im eingeschwungenen Zustand ihren mit obiger Formel angegebenen Endwert annimmt.

Die wertemäßige Dimensionierung der beiden Kapazitäten C1 und C2 bestimmt den Wert der Referenzspannung URef im eingeschwungenen Zustand; der Wert der Stützkapazität CL bestimmt die Einschwingdauer.

Bei der erfindungsgemäßen Anordnung findet ein Leistungsverbrauch nur während des Umladens der Kapazitäten C1 und C2 des kapazitiven Spannungsteilers C1C2 statt. Er ist nach folgender Formel berechenbar:

$$P = \frac{C1.C2}{C1+C2} \quad . \quad (VCC - VSS)^2 \quad . \quad f(\emptyset1),$$

wobei P den Leistungsverbrauch bedeutet und f(Ø1) die Frequenz des ersten Taktsignales Ø1 darstellt.

In vorteilhafter Weiterbildung der Erfindung enthält das Transfergate TFG zwei parallelgeschaltete Transistoren Tn,Tp vom zueinander komplementären Leitungstyp. Dabei werden der eine Transistor Tn vom zweiten Taktsignal Ø2 angesteuert und der andere Transistor Tp von einem Taktsignal $\overline{\emptyset2}$, das einen gegenüber dem zweiten Taktsignal Ø2 invertierten zeitlichen Verlauf aufweist.

Zur Verkürzung der Einschwingdauer ist es vorteilhaft, wenn an der Stützkapazität CL, wie in FIG 3 gezeigt, zusätzlich eine Start-up-Einrichtung SU vorgesehen ist. Sie dient einem Vorladen der Stützkapazität CL, so daß die Spannung U2 am Verbindungsknoten K zu Beginn des Einschwingvorganges beim Durchschalten des Transfergates TFG weniger stark absinkt als bei der (beschriebenen) Ausführung nach FIG 1.

Vorteilhafterweise ist die Start-up-Einrichtung SU als seriales Widerstandsnetzwerk zwischen der Stützkapazität CL und dem ersten Versorgungspotential VCC realisiert, insbesondere in Form von als Widerstände geschalteten Transistoren T.

Die Erfindung ist insbesondere anwendbar bei integrierten Schaltungen mit A/D- und/oder D/A-Wandlern zur Bereitstellung der dabei benötigten Referenzspannungen. Sie ist weiterhin anwendbar bei integrierten Halbleiterspeichern vom Typ DRAM mit 1-Transistor-Speicherzellen, deren Speicherkondensatoren einseitig nicht, wie früher üblich, mit einem der Versorgungspotentiale VCC,VSS verbunden sind, sondern mit einer wertemäßig zwischen diesen Potentialen liegenden Referenzspannung URef. Bei solchen Halbleiterspeichern sind, wie in FIG 4 gezeigt, die Speicherkondensatoren $C_{MC}$ der Speicherzellen MC zwischen der Referenzspannung URef und den Auswahltransistoren AT angeordnet. Die Speicherkondensatoren $C_{MC}$ weisen jedoch auch, wie der Fachmann weiß, eine parasitäre Kapazität CS zwischen der mit der Referenzspannung URef verbundenen Kondensatorelektrode E1 und dem Substrat S auf. Die gesamte, sich aus den parasitären Kapazitäten CS aller Speicherzellen MC ergebende Kapazität wird dabei als Stützkapazität CL im Sinne der vorliegenden Erfindung verwendet.

Die Erfindung wurde vorliegend beschrieben unter der Annahme, daß das erste Versorgungspotential VDD positiver sei als das zweite Versorgungspotential VSS. Die Erfindung ist jedoch auch ausführbar unter der Annahme, daß das erste Versorgungspotential VDD negativer ist als das zweite Versorgungspotential VSS. Zu diesem Zwecke sind, wie der Fachmann aufgrund seines Fachwissens leicht nachvollziehen kann, die Leitungstypen der Transistoren des CMOS-Inverters I (T1,T2) und der Entladetransistor TU sowie gegebenenfalls die Transistoren T der Start-up-Einrichtung SU gegenüber den dargestellten Leitungstypen zu tauschen in Leitungstypen vom jeweils entgegengesetzten Typ. Das Einschwingverhalten der Referenzspannung URef wird dadurch ebenfalls invertiert: Es zeigt in diesem Fall einen negativen Verlauf der Einschwingkurve, während es bei den dargestellten Ausführungsformen einen positiven Verlauf hat, wie in FIG 2 gezeigt.

**Patentansprüche**

1. Integrierte Referenzspannungsquelle mit folgenden Merkmalen:
   - Ein CMOS-Inverter (I) ist mit seinen Transistoren(T1,T2) zwischen einem ersten und einem zweiten Versorgungspotential (VCC,VSS) angeordnet sowie eingangsseitig mit einem ersten Taktsignal (∅1) verbunden,
   - eine kapazitive Spannungsteilerschaltung (C1C2) mit einer ersten und einer zweiten Kapazität (C1, C2) ist zwischen dem Ausgang des CMOS-Inverters (I) und dem zweiten Versorgungspotential (VSS) angeordnet,
   - ein Verbindungsknoten (K), der zwischen der ersten und der zweiten Kapazität (C1, C2) liegt, ist mit einem Entladetransistor (TU) und einem Transfergate (TFG) verbunden,
   - die Source des Entladetransistors (TU) ist mit dem zweiten Versorgungspotential (VSS) verbunden,
   - sein Gate ist mit dem ersten Taktsignal (∅1) verbunden,
   - am Transfergate (TFG) ist ausgangsseitig eine Stützkapazität (CL) angeordnet, an der im Betrieb die Referenzspannung (URef) als Ausgangssignal der Referenzspannungsquelle anliegt,
   - das Transfergate (TFG) ist durch ein zweites Taktsignal (∅2) gesteuert.

2. Integrierte Referenzspannungsquelle nach Anspruch 1, **dadurch gekennzeichnet,** daß das Transfergate (TFG) wenigstens zwei parallelgeschaltete Transistoren (Tn,Tp) enthält vom zueinander entgegengesetzten Leitungstyp, wobei der eine Transistor (Tn) durch das zweite Taktsignal (∅2) gesteuert ist und der andere Transistor (Tp) durch ein gegenüber dem zweiten Taktsignal (∅2) invertiertes Taktsignal ($\overline{∅2}$) gesteuert ist.

3. Integrierte Referenzspannungsquelle nach Anspruch 1 oder 2, **dadurch gekennzeichnet,** daß an der Stützkapazität (CL) weiterhin eine Start-up-Einrichtung (SU) vorgesehen ist.

4. Integrierte Referenzspannungsquelle nach Anspruch 3, **dadurch** gekennzeichnet, daß die Start-up-Einrichtung (SU) als seriales Widerstandsnetzwerk zwischen der Stützkapazität (CL) und dem ersten Versorgungspotential (VCC) realisiert ist.

5. Integrierte Referenzspannungsquelle nach Anspruch 4, **dadurch gekennzeichnet,** daß das Widerstandsnetzwerk als Widerstand geschaltete Transistoren (T) enthält.

6. Verwendung der Referenzspannungsquelle nach einem der vorhergehenden Ansprüche, **dadurch gekennzeichnet,** daß als Stützkapazität (CL) die Summe aller parasitären Kapazitäten (CS) verwendet wird, die sich bei einem integrierten Halbleiterspeicher vom Typ DRAM mit 1-Transistor-Speicherzellen (MC) zwischen mit der Referenzspannung (URef) zu beaufschlagenden Elektroden (E1) der Speicherkondensatoren ($C_{MC}$) der Speicherzellen (MC) und dem Substrat (S) des Halbleiterspeichers ausbilden.

**Claims**

1. Integrated reference-voltage source having the following features:
   - a CMOS inverter (I) is arranged with its transistors (T1, T2) between a first and a second supply potential (VCC, VSS) and is connected on the input side to a first clock signal (∅1),
   - a capacitive voltage-divider circuit (C1C2) having a first and a second capacitance (C1, C2) is arranged between the output of the CMOS inverter (I) and the second supply potential (VSS),
   - a junction node (K) which is located between the first and the second capacitance (C1, C2) is connected to a discharge transistor (TU) and to a transfer gate (TFG),
   - the source of the discharge transistor (TU) is connected to the second supply potential (VSS),
   - its gate is connected to the first clock signal (∅1),

4

- an energy-storage capacitance (CL), on which the reference voltage (URef) is present in operation as the output signal of the reference-voltage source, is arranged on the transfer gate (TFG), on the output side,
- the transfer gate (TFG) is controlled by means of a second clock signal ($\phi2$).

2. Integrated reference-voltage source according to Claim 1, characterized in that the transfer gate (TFG) contains at least two parallel-connected transistors (Tn, Tp) of mutually opposite conductance type, the one transistor (Tn) being controlled by the second clock signal ($\emptyset2$) and the other transistor (Tp) being controlled by a clock signal ($\overline{\emptyset2}$) which is inverted with respect to the second clock signal ($\phi2$).

3. Integrated reference-voltage source according to Claim 1 or 2, characterized in that a start-up device (SU) is furthermore provided on the energy-storage capacitance (CL).

4. Integrated reference-voltage source according to Claim 3, characterized in that the start-up device (SU) is implemented as a serial resistance network between the energy-storage capacitance (CL) and the first supply potential (VCC).

5. Integrated reference-voltage source according to Claim 4, characterized in that the resistance network contains transistors (T) connected as a resistor.

6. Use of the reference-voltage source according to one of the preceding claims, characterized in that the sum of all the parasitic capacitances (CS) is used as the energy-storage capacitance (CL), which parasitic capacitances (CS) are formed in the case of an integrated semiconductor store of the DRAM type having 1-transistor storage cells (MC) between electrodes (EI), to which the reference voltage (URef) is to be applied, of the storage capacitors ($C_{MC}$) of the storage cells (MC) and the substrate (S) of the semiconductor store.

**Revendications**

1. Source intégrée de tension de référence présentant les caractéristiques suivantes :
   - un inverseur CMOS (I) est disposé, avec ses transistors (T1,T2), entre un premier et un deuxième potentiels d'alimentation (VCC,VSS), et reçoit, côté entrée, un premier signal de cadence ($\emptyset1$),
   - un circuit capacitif diviseur de tension (C1,C2) comportant une première et une deuxième capacités (C1,C2), est disposé entre la sortie de l'inverseur CMOS (I) et le deuxième potentiel d'alimentation (VSS),
   - un noeud de liaison (K), qui est situé entre les première et deuxième capacités (C1,C2), est relié à un transistor de décharge (TU) et à une porte de transfert (TFG),
   - la source du transistor de décharge (TU) est reliée au deuxième potentiel d'alimentation (VSS),
   - sa porte reçoit le premier signal de cadence ($\emptyset1$),
   - à la porte de transfert (TFG) est reliée, côté sortie, une capacité porteuse (CL), à laquelle est appliquée, en fonctionnement, la tension de référence (URef) en tant que signal de sortie de la source de tension de référence,
   - la porte de transfert (TFG) est commandée par un deuxième signal de cadence ($\emptyset2$).

2. Source intégrée de tension de référence suivant la revendication 1, caractérisée par le fait que la porte de transfert (TFG) comporte au moins deux transistors (Tn,Tp) branchés en parallèle et de types de conduction réciproquement opposés, l'un des transistors (Tn) étant commandé par le deuxième signal de cadence ($\emptyset2$), tandis que l'autre transistor (Tp) est commandé par un signal de cadence ($\overline{\emptyset2}$) inversé par rapport au deuxième signal de cadence ($\emptyset2$).

3. Source intégrée de tension de référence suivant la revendication 1 ou 2, caractérisée par le fait qu'en outre un dispositif de démarrage (SU) est prévu sur la capacité porteuse (CL).

4. Source intégrée de tension de référence suivant la revendication 3, caractérisée par le fait que le dispositif de démarrage (SU) est réalisé sous la forme d'un réseau de résistances série entre la capacité porteuse (CL) et le premier potentiel d'alimentation (VCC).

**5.** Source intégrée de tension de référence suivant la revendication 4, caractérisée par le fait que le réseau de résistances comporte des transistors (T) branchés en tant que résistances.

**6.** Utilisation de la source de tension de référence selon l'une des revendications précédentes, caractérisée par le fait qu'on utilise, comme capacité porteuse (CL), la somme de toutes les capacités parasites (CS), qui, dans le cas d'une mémoire intégrée à semiconducteurs du type DRAM et comportant des cellules de mémoire (MC) à 1 transistor, sont formées entre les électrodes (E1), qui doivent être chargées par la tension de référence (URef), des condensateurs à accumulation d'énergie ($C_{MC}$) des cellules de mémoire (MC) et le substrat (S) de la mémoire à semiconducteurs.

EP 0 386 282 B1

# FIG 1

VCC

T1

Φ1

U1

K,U2  C1

T2

TU  C2

VSS

Φ̄2

Tp
Tn

Φ2

CL

URef

I    C1C2    TF6

# FIG 3

VCC

T1

Φ1

K  C1

T2

TU  C2

VSS

Φ̄2

TP
Tn

Φ2

CL

URef

T
T
T
T

SU

I    C1C2    TFG

# FIG 4

URef

MC

AT

C MC

CS

S

EP 0 386 282 B1

# FIG 2